# EUROPÄISCHE PATENTSCHRIFT

(11) **EP 4 128 370 B1**
(45) Veröffentlichungstag und Bekanntmachung des Hinweises auf die Patenterteilung: **06.08.2025**
(21) Anmeldenummer: 21716348.4
(22) Anmeldetag: 30.03.2021
(51) Int. Cl.: H10F 30/10, H10F 10/00, H01J 40/00

(54) **FESTKÖRPERBAUELEMENT**
SOLID STATE COMPONENT
COMPOSANT À L'ÉTAT SOLIDE

(30) Priorität: 31.03.2020 DE 102020002061
(43) Veröffentlichungstag der Anmeldung: 08.02.2023
(73) Patentinhaber: Siegel, Rolf, 97076 Würzburg (DE)
(72) Erfinder: Siegel, Rolf, 97076 Würzburg (DE)
(74) Vertreter: FDST Patentanwälte
(86) Internationale Anmeldenummer: PCT/EP2021/058346
(87) Internationale Veröffentlichungsnummer: WO 2021/198286

(56) Entgegenhaltungen:
- DE-A1- 102005 028 859
- DE-A1- 102011 102 886
- DE-A1- 102012 003 467
- DE-A1- 102012 010 302
- DE-A1- 102014 002 092
- DE-A1- 102016 015 581
- MCFARLAND E W ET AL: "A PHOTOVOLTAIC DEVICE STRUCTURE BASED ON INTERNAL ELECTRON EMISSION", NATURE, MACMILLAN JOURNALS LTD., ETC, LONDON, vol. 421, 6 February 2003 (2003-02-06), pages 616 - 618, XP002981794, ISSN: 0028-0836, DOI: 10.1038/NATURE01316

## Beschreibung

Die Erfindung betrifft ein Festkörperbauelement nach dem Oberbegriff des Anspruchs 1, das auf elektromagnetische Strahlung anspricht und je nach Ausführungsform als (thermo)photovoltaisches Element, als photoelektrischer Sensor, als Photokatalysator, oder als Stromspeicher eingesetzt werden kann.

Ein Festkörperbauelement nach dem Oberbegriff des Anspruchs 1 ist an sich aus DE 10 2016 015 581 A1 bekannt. Bei dem bekannten Festkörperbauelement ist auf die Anode durch einen nass-chemischen Prozess ein weiteres n-Typ-Halbleitermaterial aufgebracht, dessen Bandlücke kleiner als die Bandlücke des mit der Kathode kontaktierten n-Typ-Halbleitermaterials ist. Durch die elektronenleitende Kontaktierung der beiden Halbleitermaterialien im Elektrodenzwischenraum ist ein n-isotyper Heteroübergang gebildet.

Weitere Festkörperelemente für zumindest eine der vorstehend genannten Einsatzgebiete sind bekannt aus E. W. McFarland, J. Tang, "A photovoltaic device structure based on internal electron emission", Nature, Vol. 421, 2003 sowie aus DE 10 2005 028 859 A1 und DE 10 2014 002 092 A1.

Das erfindungsgemäße Festkörperbauelement wird definiert durch die Merkmale des Anspruchs 1. Es umfasst eine Kathode K (aus der Elektronen austreten) und eine Anode A (in die diese Elektronen eintreten). Einander gegenüberliegende Flächen der Kathode K und der Anode A begrenzen einen Elektrodenzwischenraum EZR. In dem Elektrodenzwischenraum EZR befinden sich ein Halbleitermaterial HL und ein Beschichtungsmaterial BM. Das Halbleitermaterial HL ist als n-Typ-Halbleiter nHL ausgebildet und kontaktiert die Kathode K sowie, bevorzugt, als auch das Beschichtungsmaterial BM. Das Beschichtungsmaterial BM kontaktiert die Anode A sowie, bevorzugt, auch den n-Typ-Halbleiter nHL.

Erfindungsgemäß haben die eingesetzten Materialien folgende, auf Vakuum bezogene, Energiepositionen:
i) die Austrittsarbeit Φ_{K} der Kathode K ist größer als die Austrittsarbeit Φ_{A} der Anode A (Φ_{K} > Φ_{A}),
ii) die Bandlücke E_{gHL} des n-Typ-Halbleiters nHL ist größer als 2,0 eV (E_{gnHL} > 2 eV) und seine Fermi-Energie E_{FnHL} ist größer oder (im Wesentlichen) gleich der Austrittsarbeit Φ_{K} der Kathode K (E_{FnHL} ≥ Φ_{K}), und
iii) die Austrittsarbeit des Beschichtungsmaterials BM ist kleiner als die Austrittsarbeit der Anode A (Φ_{BM} < Φ_{A}) oder das Beschichtungsmaterial BM hat eine negative Elektronenaffinität (NEA).

Zwischen der Kathode K, dem n-Typ-Halbleitermaterial nHL, dem Beschichtungsmaterial BM und der Anode A besteht elektronen-leitender Kontakt und Bereiche der Kathode (K) und der Anode (A), die nicht mit dem n-Typ-Halbleitermaterial (nHL) bzw. mit dem Beschichtungsmaterial (BM) kontaktiert sind, sind zur Bildung eines Stromkreises über Stromsammler und gegebenenfalls einen Verbraucher miteinander verbindbar oder - im Betrieb des Festkörperelements - verbunden.

Bevorzugte Ausführungsformen der Erfindung sind in den Unteransprüchen erläutert.

Ausführungsbeispiele der Erfindung werden nachfolgend anhand einer Zeichnung näher beschrieben. Darin zeigen:
- Fig. 1: in schematischer Darstellung ein Festkörperbauelement mit einer Kathode K, einem Halbleitermaterial HL in Form eines n-Typ-Halbleiters nHL, einem Beschichtungsmaterial BM und einer Anode A, sowie die auf Vakuum bezogenen Energiepositionen (in eV) dieser Komponenten im nicht-kontaktierten Zustand, und
- Fig. 2: ein Banddiagramm der eingesetzten Materialien für die Kathode K, den n-Typ-Halbleiter nHL, das Beschichtungsmaterial BM und die Anode A in elektronen-leitender Kontaktierung, unter Kurzschlussbedingungen und Einwirkung elektromagnetischer Energie hᵥ auf die Kathode K.

Einander entsprechende Teile, Größen und Strukturen sind in allen Figuren stets mit gleichen Bezugszeichen versehen.

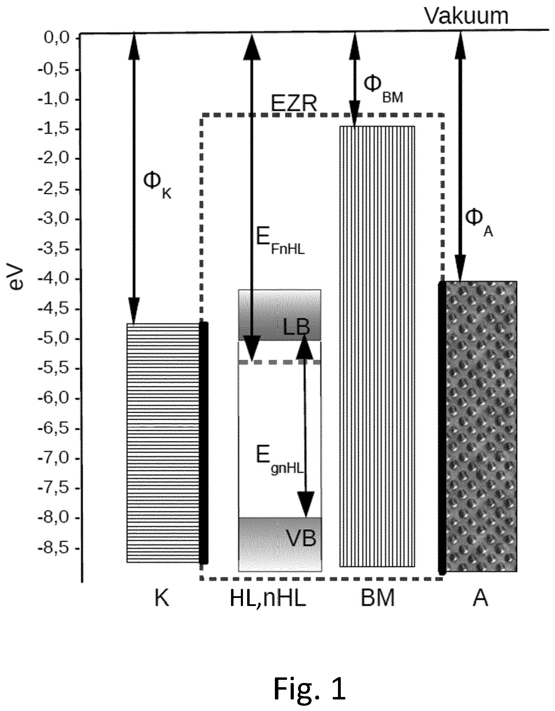

Fig. 1 zeigt schematisch die Anordnung der Komponenten eines Festkörperbauelements, nämlich
- einer Kathode K,
- eines Halbleitermaterials HL in Form eines n-Typ-Halbleiters nHL,
- eines Beschichtungsmaterial BM und
- einer Anode A
zueinander. In Fig. 1 sind weiterhin schematisch die auf Vakuum bezogenen o. g. Energiepositionen (in eV) dieser Komponenten im nicht-kontaktierten Zustand dargestellt. Die einander gegenüberliegenden Flächen der Kathode K und der Anode A begrenzen einen Elektrodenzwischenraum EZR.

Die Kathode K und die Anode A sind aus elektronen-leitenden Materialien gebildet, die entweder in elementarer Form oder als Legierungen vorliegen können. Die Elektrodenmaterialien werden dabei so ausgewählt, dass der Unterschied der Austrittsarbeit Φ_{K} der Kathode K von der Austrittsarbeit Φ_{A} der Anode A möglichst groß ist.

Nicht-limitierende Beispiele für geeignete Kathodenmaterialien sind
- Gold Au (Φ_{Au} 4,8 - 5,4 eV),
- Selen Se (Φ_{Se} 5,11 eV),
- Platin Pt (Φ_{Pt} 5,32- 5,66 eV),
- Nickel Ni (Φ_{Ni} 5,0 eV) und
- elektronen-leitender Kohlenstoff C, z.B. Graphit (Φ_{Graphit} 4,7eV).

Als nicht-limitierende Beispiele für elektronen-leitenden Kohlenstoff C seien Aktivkohletuch, Graphit (in Form von Partikeln, textilen Flächengebilden oder Folien), Fullerene, Graphen, Kohlenstoffnanoröhrchen genannt.

Nicht-limitierende Beispiele für geeignete Anodenmaterialien sind
- Magnesium Mg (Φ_{Mg} 3,7 eV),
- Barium Ba (Φ_{Ba} 1,8 - 2,52 eV),
- Cäsium Cs (Φ_{Cs} 1,7 - 2,14 eV),
- Calcium Ca (Φ_{Ca} 2,87 eV) und
- Aluminium Al (Φ_{Al} 4,0 - 4,2 eV).

Je nach Ausbildung und Einsatzgebiet des Festkörperbauelements können die den Elektrodenzwischenraum EZR bildenden Flächen der Kathode K und der Anode A kongruent oder (im mathematischen Sinne) ähnlich sein und beispielsweise im Bereich von Quadrat-Mikrometern oder auch Quadrat-Metern dimensioniert sein.

Die Kontakt(ierungs)flächen von Kathode K bzw. Anode A mit dem im Elektrodenzwischenraum EZR befindlichen Halbleitermaterial nHL bzw. Beschichtungsmaterial BM sind möglichst groß. Je nach Ausbildung und Einsatzgebiet sind die Stärken (Dicken) der Kathode K und der Anode A unterschiedlich: Bei Ausbildung als photovoltaisches Element wird beispielsweise eine dünne, Nanometer starke Kathode K aus (Blatt)Gold eingesetzt. Bei Ausbildung als (thermo)photovoltaisches Element ist die Kathode K beispielsweise eine Mikrometer oder Millimeter starke Graphitfolie oder ist aus Nanometer oder Mikrometer messenden Graphitpartikeln gebildet. Bei Ausbildung als Energiespeicher liegt die Dimensionierung der (porösen) Elektroden im Dezimeter- bzw. im Liter-Bereich.

Geeignete n-Typ-Halbleitermaterialien nHL, die die Bedingungen, E_{gnHL} > 2 eV und E_{FnHL} > F_{K}, erfüllen, können beispielsweise den Arbeiten von Shiyou Chen and Lin-Wang Wang, Chem. Mater., 2012, 24 (18), pp. 3659-3666 bzw. von J. Robertson and B. Falabretti, Electronic Structure of Transparent Conducting Oxides, pp. 27-50 in Handbook of Transparent Conductors, Springer, DOI 10.1007/978-1-4419-1638-9) entnommen werden. Wenn Graphit (mit Φ_{Graphit} ca. 4,7 eV) als Kathode K eingesetzt wird, sind dies, als nicht-limitierende Beispiele, ZnO, PbO, FeTiO₃, Ba-TiO₃, CuWO₃, BiFe₂O₃, SnO₂, TiO₂, WO₃, Fe₂O₃, In₂O₃ und Ga₂O₃.

Die dem Elektrodenzwischenraum EZR zugewandte Fläche der Anode A ist mit einem Beschichtungsmaterial BM beschichtet, dessen Austrittsarbeit Φ_{BM} noch geringer als die Austrittsarbeit Φ_{A} der Anode A ist (Φ_{BM} < Φ_{A}). Erfindungsgemäß werden hierzu Alkali-Oxide, Erdalkali-Oxide, Seltenerd-Oxid, Seltenerd-Sulfide oder hieraus bestehende binäre bzw. ternäre Verbindungen eingesetzt. Nach Literaturangaben, z.B. V.S. Fomenko und G.V. Samsonov (ed.), Handbook of Thermionic Properties, ISBN: 978-1-4684-7293-6, liegen deren Austrittsarbeiten Φ im Bereich von 0,5 - 3,3 eV. Derartige Verbindungen werden bislang zur Beschichtung von Kathodenmaterialien von Photodetektoren, Vakuumröhren, thermionischen Emittern, LEDs o. dgl. eingesetzt, um den *Austritt* von Elektronen aus dem Kathodenmaterial zu erleichtern. Im vorliegenden Fall wird davon ausgegangen, dass sie den Eintritt von Elektronen in das Material der Anode A erleichtern. Zusätzlich zu o.g. Beschichtungsmaterial BM, dessen Austrittsarbeit unterhalb der Bezugsgröße Vakuum liegt, werden auch Verbindungen mit einer oberhalb von Vakuum liegenden Austrittsarbeit eingesetzt. Hierbei handelt es sich um Verbindungen mit negativer Elektronenaffinität (NEA). Als Beispiel sei hexagonales Bornitrid (hBN) genannt.

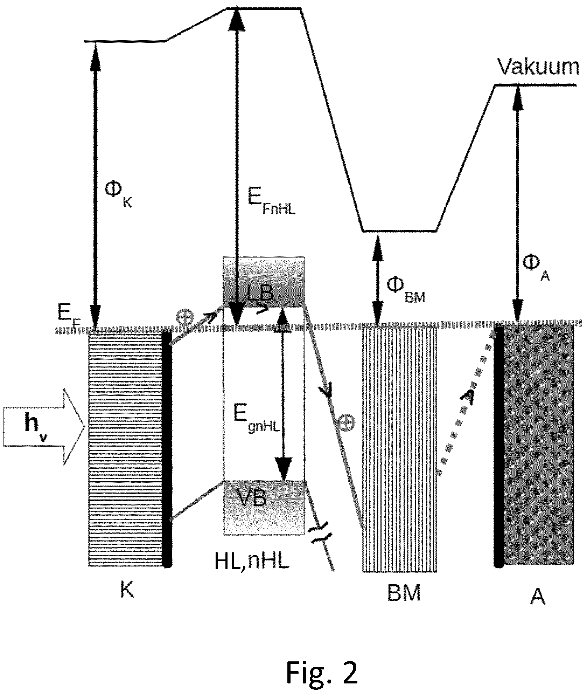

Das erfindungsgemäße Bauelement entsteht durch elektronen-leitende Kontaktierung oben beschriebener Materialien miteinander. Fig. 2 zeigt die gegenseitigen energetischen Beziehungen der Kathode K, des n-Typ-Halbleitermaterials nHL, des Beschichtungsmaterials BM und der Anode A aus Fig. 1 im kurzgeschlossenen Zustand: Eine zwischen der Kathode K und dem n-Typ-Halbleitermaterial nHL gebildete Grenzfläche K / nHL bildet einen "Schottky-Kontakt mit Elektronen-Akkumulation" (mit ⊕ gekennzeichnet). Für eine zwischen dem n-Typ-Halbleitermaterials nHL und dem Beschichtungsmaterial BM gebildete Grenzfläche nHL / BM wird ebenfalls von Elektronen-Akkumulation ⊕ ausgegangen. Eine zwischen dem Beschichtungsmaterial BM und der Anode A gebildete die Grenzfläche BM / A wird dagegen eher von Elektronen durchtunnelt (mit gestrichelter Linie skizziert). Diese Grenzflächen sind keine energetischen Barrieren für Elektronen: Selbst bei Raumtemperatur und Dunkelheit können sie die energetisch tiefer gelegene Kathode K verlassen und in die energetisch höher liegende Anode A eintreten - was durch einen kontinuierlichen Anstieg der offenen Klemmenspannung Voc, siehe Beispiel 1, belegt wird.

Zur Funktionsweise: Durch elektromagnetische Strahlung, die mit ausreichend großer Energie auf die Kathode K einwirkt, werden - direkt oder indirekt über Phononen und Plasmonen - Elektronen im Volumen des Kathoden-Materials derart angeregt, dass sie in der Lage sind, das Kathoden-Material zu verlassen und in das Leitungsband des n-Typ-Halbleitermaterials nHL einzutreten, was aufgrund der an der Grenzfläche K / nHL bestehenden Elektronen-Akkumulation ⊕ (leicht) möglich ist. Haben die Elektronen weiterhin ausreichend (kinetische) Energie, gelangen sie über die Grenzfläche nHL / BM hinweg in das Volumen des Beschichtungsmaterials BM, um über die Grenzfläche BM / A hinweg in das Volumen der energetisch höher gelegenen Anode A einzutreten. Da das n-Typ-Halbleitermaterial nHL eine Bandlücke E_{gHL} von mehr als 2 eV aufweist, kommt es zu keiner Rekombination mit Löchern aus dem Valenzband.

Für den Betrieb des Festkörperbauelements werden n-typ-halbleiter-freie Anteile der Kathode K und beschichtungsmaterial-freie Anteile der Anode A durch einen oder mehrere elektrische Leiter und gegebenenfalls einen dazwischen geschalteten elektrischen Verbraucher zu einem Stromkreis verbunden. Der oder die genannten elektrischen Leiter und der ggf. vorhandene Verbraucher bilden dabei einen - nicht zu dem erfindungsgemäßen Festkörperbauelement gehörenden - äußeren Teil des Stromkreises. In diesem Betriebszustand des Festkörperbauelements sind ausreichend "heiße" Elektronen in der Lage, elektrische Arbeit zu verrichten, da sie von der energetisch höher liegende Anode A über den äußeren Anteil des Stromkreises wieder zur Kathode K zurückfließen. Somit eignet sich das Bauelement u.a. auch als (thermo)photovoltaische Zelle zur Umwandlung von Wärmeenergie in elektrische Energie.

Für die jeweilige elektronen-leitende Kontaktierung der eingesetzten Materialien können bekannte (Halbleiter)Technologien wie spin coating, (elektrostatische) Fixierung von (Nano)Kristallen, Kathodenzerstäubung (Sputtern), atomic layer deposition (ALD), Epitaxie, chemical vapor deposition (CVD), physical vapor deposition (PVD), chemical bath deposition (CBD) oder (elektro)chemische Methoden eingesetzt werden.

Parameter wie zum Beispiel Kontaktierungsbedingungen (Temperatur, Druck, Gasatmosphäre, Luftfeuchtigkeit, pH von Lösungen), stöchiometrische Zusammensetzung der Elektroden- und/oder Halbleitermaterialien, deren Rauigkeit, deren Stellung in der thermoelektrischen bzw. elektrochemischen Spannungsreihe, Ausbildung von (Dipol- )Schichten, Kristallgröße, Kristallflächenorientierung, Kristallinität, Kristallwasser-(Anteil), Art und Ausmaß der Gitterdefekte, Art und Ausmaß der Dotierung, Gitteranpassung, Schichtmorphologie, Dicke der aufgebrachten Schicht(en), deren Porosität, etc., sind dem Fachmann geläufig, sind in weiten Bereichen variierbar und sind (auf Basis gewonnener Versuchsergebnisse) optimierbar.

### Beispiel 1:

Eingesetzte Materialien:
- Das Material für die Kathode K ist Graphit mit einer Austrittarbeit Φ_{K} von 4,7 eV.
- Das Material für die Anode A ist Magnesium mit einer Austrittarbeit Φ_{A} von 3,7 eV.
- Das Beschichtungsmaterial BM für die Anode A ist Bariumoxid mit einer Austrittsarbeit Φ_{BM} von 1,9 eV.
- Das n-Typ-Halbleitermaterial nHL ist Zinn(IV)oxid SnO₂.

Gemäß Literatur wird von einer Energieposition des Leitungsbands LB von 5,1 eV; einer Fermi-Energie E_{FSnO2} von 5,3 eV, einer Energieposition des Valenzbands VB von 8,6 eV und einer Bandlücke E_{gSnO2} von 3,5 eV ausgegangen.

Herstellung des Bauelements:

### I) Elektronen-leitende Kontaktierung der Kathode K mit dem n-Typ-Halbleitermaterial nHL

Aktivkohletuch (FLEXSORB FM30K) der Fa. "Chemviron Cloth Divison", Tyne & Wear (UK) wird mit einer Lösung von ca. 2,0%iger (w/v) Sn(II)Cl₂*2H₂O in 70%iger (v/v) 2-Propanol-Lösung in Wasser über 5 Stunden vollständig bedeckt. Nach Entfernen überschüssiger Lösung wird eine Seite des feuchten Tuchs für ca. 12 Stunden einer Ammoniak-Atmosphäre ausgesetzt. Anschließend wird das Tuch über mehrere Stunden bei ca. 50°C getrocknet. Bei der entstandenen silbrig-glänzenden Schicht handelt es um (Kassiterit-)Kristalle von Zinn(IV)oxid SnO₂.

### II) Elektronen-leitende Kontaktierung der Anode A mit dem Beschichtungsmaterial BM

Ein ca. 17 mm langer Anteil eines 20 x 3,2 x 0,3 mm messenden Magnesiumbands wird für ca. 2 Sekunden in 1n Salzsäure getaucht, wodurch unter Wasserstoffentwicklung die anhaftende Oxidschicht entfernt wird. Nach Abtrocknen mit einem weichen Papiertuch werden auf den mit Säure kontaktierten Anteil ca. 10 µl einer gesättigten, ca. 90°C heißen wässrigen Bariumoxid-Lösung mit einer Pipette aufgeträufelt. Danach wird das Band, mit der behandelten Seite nach oben, auf einer auf einem Bunsenbrenner liegenden Platte aus Glaskohlenstoff für ca. 30 min bei einer geschätzten Temperatur von ca. 900°C wärmebehandelt. Bei der entstandenen graufarbene Schicht handelt es sich um Bariumoxid BaO.

### III) Zusammenbau zum Festkörperbauelement

Die gemäß II) hergestellte Anode A wird mit der unbehandelten Seite auf ein selbstklebendes Klebeband (Tesafilm^{®}) fixiert. Die gemäß I) hergestellte Kathode K wird mit der silbrig-glänzenden Seite deckungsgleich derart auf der Anode A fixiert, dass das nicht mit Salzsäure behandelte Ende sowie ca. 2 mm der graufarbenen BaO-Schicht ausgespart bleiben, was zu einer ca. 15 x 3,2 mm messenden elektronen-leitenden Kontaktfläche der Anode A führt. Als kathodischer Stromsammler wird ein 0,1 mm starker Kupferdraht mittels Klebeband (Tesafilm^{®}) auf dem Aktivkohletuch fixiert; als anodischer Stromsammler dient das nicht mit Salzsäure kontaktierte Ende des Magnesiumbands, wobei die hier befindliche Oxidschicht noch mechanisch entfernt wird.

Das so hergestellte Bauteil wird dann zwischen zwei Objektträger aus Glas gelegt, wobei der obere Objektträger so bemessen ist, dass Zuleitungen eines Multimeters an o.g. Stromsammler angeschlossen werden können. Die elektronenleitende Kontaktierung von Kathode K mit Anode A erfolgt durch Zusammendrücken und Fixieren der beiden Objektträger mittels Klammern. Um Handhabbarkeit und Stabilität des Bauelements zusätzlich zu erhöhen, kann es, unter Aussparung der Stromsammler, in eine optisch klaren 2K-Epoxy-Vergussmasse eingebracht werden und die dann ausgehärtet wird.

Das derart hergestellte Bauelement wird in einen Stromkreis dadurch integriert, indem man den (kathodischen) Kupferdraht mit dem Pluspol eines Multimeters verbindet und das freie Ende des (anodischen) Magnesiumbands mit dem Minuspol.

Bei Messungen des Kurzschlussstroms Isc finden sich bei Raumtemperatur und Raumlicht durchweg Werte von 5 µA/cm². Bei Sonnenschein werden, durch den auf die Kathode K gerichteten Brennfleck einer Lupe, Werte um 2.000 µA/cm² erzielt. Erfolgt die Messung der offenen Klemmenspannung Voc unmittelbar nach einer derartigen Isc-Messung, so finden sich Voc-Werte um 0,7 Volt. Selbst bei Raumtemperatur und Dunkelheit kommt es dann, innerhalb von ca. acht Stunden, zu einem Anstieg des Voc-Wertes auf ca. 1,8 Volt. Wird beim maximalen Voc-Wert eine Isc-Messung vorgenommen, so finden sich initial Stromwerte von 400 µA/cm², die dann kontinuierlich innerhalb von ca. 20 min auf Werte um 20 µA/cm² abfallen. Somit eignet sich das Bauelement als Energiespeicher, u.a. auch in Form eines sich selbstaufladenden Kondensators.

Die offene Klemmenspannung Voc des (in Epoxy eingegossenen) Bauelements ist, über Monate hinweg, mit ca. 1,8 Volt konstant, was sich auch in fehlender Korrosion der Anode A widerspiegelt.

Die o.g. genannte Dimensionierung von Kathode K und Anode A wird für folgende Bespiele beibehalten.

### Beispiel 2:

Als n-Typ-Halbleiter nHL wird TiO₂ eingesetzt. Energiepositionen: Leitungsband LB 4,6 eV; Fermi-Energie E_{FTiO2} 5,3 eV; Valenzband VB 7,8 eV und Bandlücke E_{gTiO2} 3,7 eV. Das Aktivkohletuch (Kathode K) wird mit einer 1 %igen (v/v) Lösung von Titan(IV)ethylat in 2-Propanol imprägniert und über mehrere Tage bei 90°C getrocknet. Anode A und Beschichtungsmaterial BM wie im Beispiel 1. Kontaktierung des (aufgrund von TiO₂-Bildung weißgefärbtem) Aktivkohletuch mit BaObeschichteter Anode A und Zusammenbau wie in Beispiel 1 beschrieben. Messergebnisse wie bei Beispiel 1.

### Beispiel 3:

Als n-Typ-Halbleiter nHL wird Fe₂O₃ eingesetzt. Energiepositionen: Leitungsband LB 5,0 eV; Fermi-Energie E_{FFe2O3} 5,3 eV; Valenzband VB 7,3 eV und Bandlücke E_{gFe2O3} 2,3 eV. Anode A und Beschichtungsmaterial BM wie im Beispiel 1. Aufbringen von ca. 10 µl einer wässrigen, gesättigten Lösung von Fe(III)nitrat auf die Beschichtungsfläche aus BaO. Zunächst Trocknung bei Raumtemperatur und danach Wärmebehandlung wie in Beispiel 1. Kontaktierung mit nicht-modifiziertem Aktivkohletuch (Kathode K) und Zusammenbau wie bei Beispiel 1. Messergebnisse wie bei Beispiel 1.

### Beispiel 4:

Als Beschichtungsmaterial BM wird Calciumoxid CaO eingesetzt. Reinigen der wiederum aus Magnesium bestehenden Anode wie bei Beispiel 1. Aufbringen von ca. 10 µl einer wässrigen, gesättigten Lösung von Calciumnitrat Ca(NO₃)₂ auf die gereinigte Magnesiumoberfläche und anschließende Wärmebehandlung bei ca. 900°C. Danach Aufbringen von ca. 10 µl einer wässrigen, gesättigten Lösung von Fe(III)nitrat auf die Beschichtungsfläche aus CaO zur Bildung der aus Fe₂O₃ bestehenden Halbleiterschicht (analog Beispiel 3). Zunächst Trocknung bei Raumtemperatur und danach Erhitzen wie in Beispiel 1. Kontaktierung mit unbehandeltem Aktivkohletuch und Zusammenbau wie bei Beispiel 1. Messergebnisse wie in Beispiel 1.

### Beispiel 5:

Als Beschichtungsmaterial BM wird Strontiumoxid SrO eingesetzt. Reinigen der wiederum aus Magnesium bestehenden Anode A wie bei Beispiel 1. Aufbringen von ca. 10 µl einer wässrigen, gesättigten Lösung von Strontiumnitrat Sr(NO₃)₂ auf die gereinigte Magnesiumoberfläche und anschließende Wärmebehandlung bei ca. 900°C. Danach Aufbringen von ca. 10 µl einer wässrigen, gesättigten Lösung von Fe(III)nitrat auf die Beschichtungsfläche mit SrO, um die aus Fe₂O₃ bestehende Halbleiterschicht zu bilden (analog Beispiel 3). Zunächst Trocknung bei Raumtemperatur und danach Erhitzen wie bei Beispiel 1. Kontaktierung mit unbehandeltem Aktivkohletuch (Kathode K) und Zusammenbau wie bei Beispiel 1. Messergebnisse wie in Beispiel 1.

### Beispiel 6:

Als Beschichtungsmaterial BM wird Cäsiumoxid Cs₂O eingesetzt. Reinigen der wiederum aus Magnesium bestehenden Anode A wie bei Beispiel 1. Lösen einer Spatelspitze von Cäsiumiodid CsJ in ca. 10 ml verdünnter KOH. Aufbringen von 10 µl auf die gereinigte Magnesiumoberfläche und anschließende Wärmebehandlung bei ca. 900°C. Danach Aufbringen von ca. 10 µl einer wässrigen, gesättigten Lösung von Fe(III)nitrat auf die Beschichtungsfläche mit Cs₂O, um die aus Fe₂O₃ bestehende Halbleiterschicht zu bilden (analog Beispiel 3). Zunächst Trocknung bei Raumtemperatur und danach Erhitzen wie bei Beispiel 1. Kontaktierung mit unbehandeltem Aktivkohletuch und Zusammenbau wie bei Beispiel 1. Messergebnisse wie in Beispiel 1.

### Beispiel 7:

Als Beschichtungsmaterial BM wird hexagonales Bornitrid hBN eingesetzt. Reinigen der wiederum aus Magnesium bestehenden Anode A wie bei Beispiel 1. Dispergieren einer Spatelspitze von hBN in ca. 10 ml Ethylacetat. Aufbringen von 10 µl der Dispersion auf die gereinigte Magnesiumoberfläche, nach Abdampfen von Ethylacetat, Wärmebehandlung bei ca. 900°C über 30 min. Danach Aufbringen von ca. 10 µl einer wässrigen, gesättigten Lösung von Fe(III)nitrat auf die Beschichtungsfläche mit hBN, um die aus Fe₂O₃ bestehende Halbleiterschicht zu bilden (analog Beispiel 3). Zunächst Trocknung bei Raumtemperatur und danach Erhitzen wie bei Beispiel 1. Kontaktierung mit unbehandeltem Aktivkohletuch und Zusammenbau wie bei Beispiel 1. Messergebnisse wie in Beispiel 1.

Zusammenfassend sind bei dem Festkörperbauelement einander gegenüberliegende asymmetrische Elektroden, nämlich die Kathode K und die Anode A, mittels eines Halbleitermaterials HL und eines Beschichtungsmaterials BM derart elektronen-leitend miteinander verbunden, dass durch einwirkende elektromagnetische Strahlung eine offene Klemmenspannung Voc von ca. 1,8 Volt oder sogar mehr erzielt wird.

## Patentansprüche

1. Festkörperbauelement zum Einsatz als (thermo)photovoltaisches Element,
als photoelektrischer Sensor, als Photokatalysator, oder als Stromspeicher, umfassend
- eine Kathode (K), die elektromagnetischer Strahlung aussetzbar ist,
- eine Anode (A),
- einen Elektrodenzwischenraum (EZR), der von gegenüberliegenden Flächen von Kathode (K) und Anode (A) gebildet wird,
- ein Halbleitermaterial (HL) im Elektrodenzwischenraum (EZR) und
- ein Beschichtungsmaterial (BM) im Elektrodenzwischenraum (EZR), wobei zur Erzielung eines Elektronenflusses zwischen Kathode (K) und Anode (A)
- die Austrittsarbeit (Φ_{K}) des Materials der Kathode (K) größer ist als die Austrittsarbeit (Φ_{A}) des Materials der Anode (A),
- das Halbleitermaterial (HL) die Kathode (K) im Elektrodenzwischenraum (EZR) kontaktiert und ein n-Typ-Halbleitermaterial (nHL) ist, dessen Bandlücke (E_{gHL}) größer als 2,0 eV ist und dessen Fermi-Energieposition (E_{FnHL}) gleich oder größer als die Austrittsarbeit (Φ_{K}) der Kathode (K) ist,
- das Beschichtungsmaterial (BM) die Anode (A) im Elektrodenzwischenraum (EZR) kontaktiert,
- zwischen der Kathode (K), dem n-Typ-Halbleitermaterial (nHL), dem Beschichtungsmaterial (BM) und der Anode (A) elektronen-leitender Kontakt besteht, und
- Bereiche der Kathode (K) und der Anode (A), die nicht mit dem n-Typ-Halbleitermaterial (nHL) bzw. mit dem Beschichtungsmaterial (BM) kontaktiert sind, zur Bildung eines Stromkreises über Stromsammler und gegebenenfalls einen Verbraucher miteinander verbindbar sind,
**dadurch gekennzeichnet,**
**dass** das Beschichtungsmaterial (BM) eine Austrittsarbeit (Φ_{BM}) hat, die kleiner als die Austrittsarbeit der Anode (A) ist, oder dass das Beschichtungsmaterial (BM) eine negative Elektronenaffinität (NEA) hat.

2. Festkörperbauelement nach Anspruch 1,
wobei das Material der Kathode (K) elektronen-leitender Kohlenstoff ist.

3. Festkörperbauelement nach Anspruch 1 oder 2,
wobei das Material der Anode (A) Magnesium oder eine Magnesiumlegierung ist.

4. Festkörperbauelement nach einem der Ansprüche 1 bis 3, wobei das Beschichtungsmaterial (BM) ein Alkali-Oxid, ein Erdalkali-Oxid, ein Seltenerd-Oxid, ein Seltenerd-Sulfid ist oder eine hieraus bestehende binäre bzw. ternäre Verbindung oder ein Material mit negativer Elektronenaffinität ist.

5. Festkörperbauelement nach einem der Ansprüche 1 bis 3, wobei das Beschichtungsmaterial (BM) Bariumoxid BaO, Calciumoxid CaO, Strontiumoxid SrO, Cäsiumoxid Cs₂O oder hexagonales Bornitrid hBN ist.

6. Festkörperbauelement nach einem der Ansprüche 1 bis 5, wobei das n-Typ-Halbleitermaterial (nHL) ZnO, Fe₂O₃, PbO, FeTiO₃, BaTiO₃, CuWO₃, BiFe₂O₃, SnO₂, TiO₂, WO₃, In₂O₃ oder Ga₂O₃ ist.

## Claims

1. Solid-state component for use as (thermo) photovoltaic element, as photoelectric sensor, as photocatalyst, or as power storage means, comprising
- a cathode (K) exposable to electromagnetic radiation,
- an anode (A),
- an electrode gap (EZR) formed by opposing surfaces of cathode (K) and anode (A),
- a semiconductor material (HL) in the electrode gap (EZR) and
- a coating material (BM) in the electrode gap (EZR), where an electron flow between cathode (K) and anode (A) is achieved in that
- the work function (Φ_{K}) of the material of the cathode (K) is greater than the work function (Φ_{A}) of the material of the anode (A),
- the semiconductor material (HL) makes contact with the cathode (K) in the electrode gap (EZR) and is an n-type semiconductor material (nHL) having a bandgap (E_{gHL}) of greater than 2.0 eV and having a Fermi energy position (E_{FnHL}) equal to or greater than the work function (Φ_{K}) of the cathode (K),
- the coating material (BM) makes contact with the anode (A) in the electrode gap (EZR),
- there is an electron-conducting contact between the cathode (K), the n-type semiconductor material (nHL), the coating material (BM) and the anode (A), and
- regions of the cathode (K) and of the anode (A) that are not in contact with the n-type semiconductor material (nHL) or with the coating material (BM) are connectable to one another to form a circuit via current collectors and optionally a load,
**characterized in that**
the coating material (BM) has a work function (Φ_{BM}) smaller than the work function of the anode (A), or **in that** the coating material (BM) has a negative electron affinity (NEA).

2. Solid-state component according to Claim 1, wherein the material of the cathode (K) is electron-conducting carbon.

3. Solid-state component according to Claim 1 or 2, wherein the material of the anode (A) is magnesium or a magnesium alloy.

4. Solid-state component according to any of Claims 1 to 3,
wherein the coating material (BM) is an alkali metal oxide, an alkaline earth metal oxide, a rare earth metal oxide, a rare earth metal sulfide or a binary or ternary compound consisting thereof or a material having negative electron affinity.

5. Solid-state component according to any of Claims 1 to 3,
wherein the coating material (BM) is barium oxide BaO, calcium oxide CaO, strontium oxide SrO, caesium oxide Cs₂O or hexagonal boron nitride hBN.

6. Solid-state component according to any of Claims 1 to 5,
wherein the n-type semiconductor material (nHL) is ZnO, Fe₂O₃, PbO, FeTiO₃, BaTiO₃, CuWO₃, BiFe₂O₃, SnO₂, TiO₂, WO₃, In₂O₃ or Ga₂O₃.

## Revendications

1. Composant à l'état solide destiné à être utilisé comme élément (thermo)photovoltaïque, comme capteur photoélectrique, comme photocatalyseur, ou comme dispositif de stockage d'énergie, comprenant
- une cathode (K) pouvant être exposée à un rayonnement électromagnétique,
- une anode (A),
- un espace inter-électrodes (EZR) formé par les surfaces opposées de la cathode (K) et de l'anode (A),
- un matériau semi-conducteur (HL) dans l'espace inter-électrodes (EZR) et
- un matériau de revêtement (BM) dans l'espace inter-électrodes (EZR),
dans lequel, pour obtenir un flux d'électrons entre la cathode (K) et l'anode (A)
- le travail de sortie (Φ_{K}) du matériau de la cathode (K) est supérieur au travail de sortie (Φ_{A}) du matériau de l'anode (A),
- le matériau semi-conducteur (HL) entre en contact avec la cathode (K) dans l'espace inter-électrodes (EZR) et est un matériau semi-conducteur de type n (nHL) dont la bande interdite (E_{gHL}) est supérieure à 2,0 eV et dont la position d'énergie de Fermi (E_{FnHL}) est égale ou supérieure au travail de sortie (Φ_{K}) de la cathode (K),
- le matériau de revêtement (BM) entre en contact avec l'anode (A) dans l'espace inter-électrodes (EZR),
- il existe un contact conducteur d'électrons entre la cathode (K), le matériau semi-conducteur de type n (nHL), le matériau de revêtement (BM) et l'anode (A), et
- des zones de la cathode (K) et de l'anode (A), qui n'entrent pas en contact avec le matériau semi-conducteur de type n (nHL) ou avec le matériau de revêtement (BM), peuvent être reliées entre elles pour former un circuit électrique par l'intermédiaire de collecteurs de courant et éventuellement d'un consommateur,
**caractérisé en ce que**
le matériau de revêtement (BM) a un travail de sortie (Φ_{BM}) qui est inférieur au travail de sortie de l'anode (A), ou **en ce que** le matériau de revêtement (BM) a une affinité électronique négative (NEA).

2. Composant à l'état solide selon la revendication 1, dans lequel le matériau de la cathode (K) est du carbone conducteur d'électrons.

3. Composant à l'état solide selon la revendication 1 ou 2,
dans lequel le matériau de l'anode (A) est du magnésium ou un alliage de magnésium.

4. Composant à l'état solide selon l'une quelconque des revendications 1 à 3,
dans lequel le matériau de revêtement (BM) est un oxyde alcalin, un oxyde alcalino-terreux, un oxyde de terres rares, un sulfure de terres rares, ou un composé binaire ou ternaire de ceux-ci, ou un matériau ayant une affinité électronique négative.

5. Composant à l'état solide selon l'une quelconque des revendications 1 à 3,
dans lequel le matériau de revêtement (BM) est l'oxyde de baryum BaO, l'oxyde de calcium CaO, l'oxyde de strontium SrO, l'oxyde de césium Cs₂O ou le nitrure de bore hexagonal hBN.

6. Composant à l'état solide selon l'une quelconque des revendications 1 à 5,
dans lequel le matériau semi-conducteur de type n (nHL) est ZnO, Fe₂O₃, PbO, FeTiO₃, BaTiO₃, CuWO₃, BiFe₂O₃, SnO₂, TiO₂, WO₃, In₂O₃ ou Ga₂O₃.
